(19) **Europäisches Patentamt / European Patent Office / Office européen des brevets**

(11) **EP 4 016 762 B1**

(12) **FASCICULE DE BREVET EUROPEEN**

(45) Date de publication et mention de la délivrance du brevet:
**19.07.2023 Bulletin 2023/29**

(51) Classification Internationale des Brevets (IPC):
**H01S 5/10** *(2021.01)* **H01S 5/12** *(2021.01)*
**H01S 5/20** *(2006.01)* **H01S 5/22** *(2006.01)*
**H01S 5/34** *(2006.01)* **H01S 5/042** *(2006.01)*

(21) Numéro de dépôt: **21215739.0**

(22) Date de dépôt: **17.12.2021**

(52) Classification Coopérative des Brevets (CPC):
**H01S 5/1237; H01S 5/04253; H01S 5/22;**
H01S 5/04254; H01S 5/1082; H01S 5/2027;
H01S 5/209; H01S 5/3401; H01S 2301/176;
H01S 2301/18

(54) **LASER COMPRENANT UN MIROIR DE BRAGG DISTRIBUÉ ET PROCÉDÉ DE RÉALISATION**

LASER MIT EINEM VERTEILTEN BRAGG-SPIEGEL UND SEIN HERSTELLUNGSVERFAHREN

LASER COMPRISING A DISTRIBUTED BRAGG REFLECTOR AND METHOD FOR MANUFACTURING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.12.2020 FR 2013657**

(43) Date de publication de la demande:
**22.06.2022 Bulletin 2022/25**

(73) Titulaire: **Commissariat à l'Energie Atomique et aux Energies Alternatives**
**75015 Paris (FR)**

(72) Inventeurs:
• **REBOUD, Vincent**
  **38054 GRENOBLE Cedex 09 (FR)**
• **FOURNIER, Maryse**
  **38054 GRENOBLE Cedex 09 (FR)**
• **FEDELI, Jean-Marc**
  **38054 GRENOBLE Cedex 09 (FR)**

(74) Mandataire: **Hautier IP**
**20, rue de la Liberté**
**06000 Nice (FR)**

(56) Documents cités:
**EP-A1- 1 833 128     US-A1- 2020 203 925**

• **DRIDI K ET AL:** "Narrow-linewidth and single-mode 1.55 m laterally-coupled distributed feedback laser fabricated by standard I-line stepper lithography", COMMUNICATIONS AND PHOTONICS CONFERENCE (ACP), 2012 ASIA, IEEE, 7 novembre 2012 (2012-11-07), pages 1-3, XP032389820, ISBN: 978-1-4673-6274-0
• **WANG Q C ET AL:** "1.3 [mu]m Laterally Coupled Distributed Feedback Laser with High Side Mode Suppression Ratio and Bandwidth", 2019 ASIA COMMUNICATIONS AND PHOTONICS CONFERENCE (ACP), OSA, 2 novembre 2019 (2019-11-02), pages 1-3, XP033709371,
• **WANG Q C ET AL:** "1.3[mu]m laterally coupled distributed feedback laser with a triangular prism etched facet", ENHANCED AND SYNTHETIC VISION 2003 : [CONFERENCE ENHANCED AND SYNTHETIC VISION 2002] ; 21 APRIL 2003, ORLANDO, FLORIDA, USA; [PROCEEDINGS OF SPIE ISSN 0277-786X], SPIE, US, vol. 11023, 12 mars 2019 (2019-03-12), pages 110233Z-110233Z, XP060116376, DOI: 10.1117/12.2517896 ISBN: 978-1-5106-3673-6
• **CHENG-AO YANG ET AL:** "2-[mu]m single longitudinal mode GaSb-based laterally coupled distributed feedback laser with regrowth-free shallow-etched gratings by interference lithography", CHINESE PHYSICS B, CHINESE PHYSICS B, BRISTOL GB, vol. 25, no. 2, 4 février 2016 (2016-02-04), page 24204, XP020296450, ISSN: 1674-1056, DOI: 10.1088/1674-1056/25/2/024204 [extrait le 2016-02-04]

**EP 4 016 762 B1**

- **KOETH J ET AL: "Mid infrared DFB interband cascade lasers", PROCEEDINGS OF SPIE; [PROCEEDINGS OF SPIE ISSN 0277-786X VOLUME 10524], SPIE, US, vol. 10403, 30 août 2017 (2017-08-30), pages 1040308-1040308, XP060095277, DOI: 10.1117/12.2277698 ISBN: 978-1-5106-1533-5**
- **SLIGHT T J ET AL: "Short wavelength distributed feedback quantum cascade laser", LASERS AND ELECTRO-OPTICS, 2009 AND 2009 CONFERENCE ON QUANTUM ELECTRONICS AND LASER SCIENCE CONFERENCE. CLEO/QELS 2009. CONFERENCE ON, IEEE, PISCATAWAY, NJ, USA, 2 juin 2009 (2009-06-02), pages 1-2, XP031521523, ISBN: 978-1-55752-869-8**

**Description**

**DOMAINE TECHNIQUE**

La présente invention concerne le domaine de l'optoélectronique. Elle peut être mise en oeuvre pour la réalisation de composants émetteurs de lumière, notamment dans le domaine du moyen infrarouge (MIR). Elle trouve pour application particulièrement avantageuse la réalisation de miroirs de Bragg distribués pour des sources laser à cascade quantique en technologie compatible CMOS. Un exemple d'application particulier concerne les capteurs environnementaux utilisant des sources MIR.

**ETAT DE LA TECHNIQUE**

Un laser comprenant un réflecteur de Bragg distribué est appelé laser à rétroaction répartie DFB (pour « Distributed FeedBack » signifiant « rétroaction distribuée » ou « rétroaction répartie »).

Le laser peut être basé sur un principe d'amplification à cascade quantique. Un tel laser est alors dit LCQ (pour Laser à Cascade Quantique).

Un principe de fonctionnement du laser à cascade quantique est le suivant : la région active du laser est polarisée électriquement via des électrodes, de façon à injecter des électrons. Cette région active comprend typiquement une multitude de puits quantiques dans lesquels un électron va perdre successivement une partie de son énergie, en cascade, en émettant à chaque fois un photon d'énergie donnée. Ces photons forment le rayonnement lumineux de longueur d'onde $\lambda$.

Ce rayonnement lumineux se propage de façon guidée au sein de la cavité optique du laser. Cette cavité optique est typiquement bornée par des couches inférieures et supérieures dites LOC (acronyme de « Low Optical Confinement » signifiant confinement [par une couche de] bas indice optique), et au moins un réflecteur de Bragg.

Le réflecteur de Bragg distribué est un miroir permettant de réfléchir un rayonnement lumineux de longueur d'onde $\lambda$ donnée avec une réflectivité R supérieure à 99%. Un tel miroir comprend typiquement des corrugations périodiques présentant des indices de réfraction différents. Une réflexion partielle du rayonnement lumineux se produit à chaque alternance d'indices. Pour un pas de réseau de l'ordre de $\Lambda = m.\lambda/2n$, n étant l'indice de réfraction effectif et m l'ordre du réseau, les réflexions partielles se combinent par interférences constructives, et les corrugations « distribuées » le long du réseau agissent comme un miroir de grande qualité.

Les réflecteurs ou miroirs de Bragg distribués sont donc particulièrement avantageux pour la fabrication de lasers monomodes présentant une largeur spectrale très étroite.

Parmi les nombreuses applications des systèmes optiques comprenant des lasers LCQ DFB, la détection d'éléments chimiques ou biologiques ($CO_2$, $CH_4$, $NH_3$..., glucose ...) est particulièrement intéressante. La largeur spectrale très étroite des lasers LCQ DFB permet en effet d'augmenter avantageusement la sensibilité de détection.

Les performances de ces lasers LCQ DFB dépendent notamment de la qualité des réflecteurs de Bragg distribués et de la qualité d'injection des électrons dans la région active.

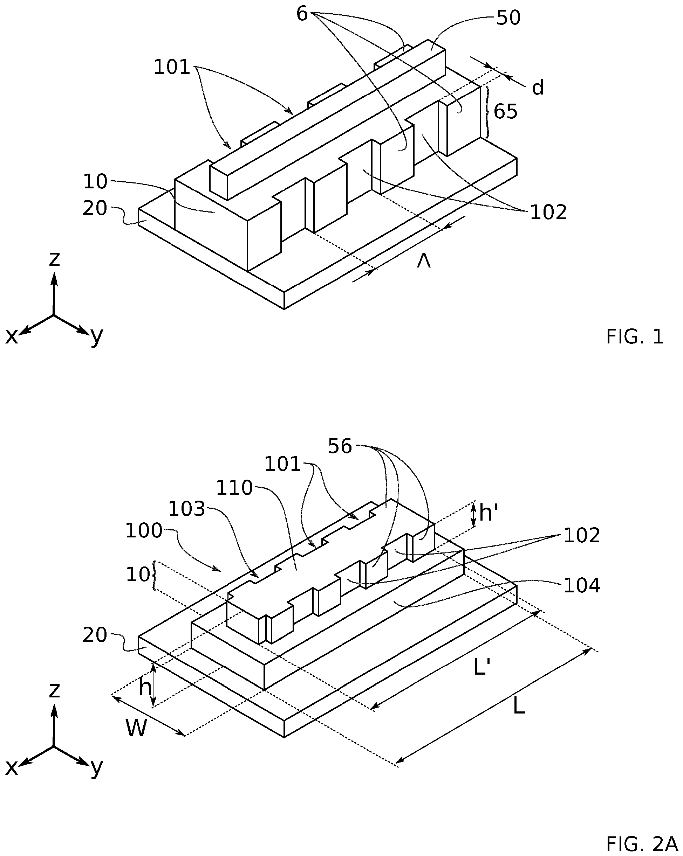

Le document US 2015333482 A1 divulgue une architecture de laser LCQ DFB destiné à émettre un rayonnement lumineux monochromatique selon une direction longitudinale x. Comme illustré schématiquement sur la figure 1, les éléments essentiels de cette architecture comprend un empilement 10 selon z de couches à base de matériaux III-V, et un réflecteur de Bragg 65 formé par des corrugations 6 latérales périodiques de période $\Lambda$ sur les flancs latéraux 101, 102 de l'empilement 10.

Cette architecture comprend en outre une électrode supérieure 50 disposée sur le sommet de l'empilement 10 de couches. Une telle architecture permet d'injecter des électrons via l'électrode supérieure, tout en présentant une bonne réflectivité via la structuration DFB latérale.

Les documents EP 1833128 A1, « 1.3 $\mu$m laterally coupled distributed feedback laser with high side mode suppression ratio and bandwidth, Wang Q.C et al., Asia communications and photonics conférence, pp.1-3 (2019) », « narrow linewidth and single mode 1,55 $\mu$m laterally coupled distributed feedback laser fabricated by standard I-line stepper lithography, Dridi K. et al., Asia communications and photonics conférence, pp.1-3 (2012) » divulguent également des architectures de laser DFB à corrugations latérales.

Il existe cependant un besoin consistant à améliorer encore les performances d'un laser à structuration DFB latérale.

Un objet de la présente invention est donc de proposer un laser à structuration DFB latérale présentant des performances améliorées.

Un autre objet de la présente invention est de proposer un procédé de fabrication d'un tel laser.

Les autres objets, caractéristiques et avantages de la présente invention apparaîtront à l'examen de la description suivante et des dessins d'accompagnement. Il est entendu que d'autres avantages peuvent être incorporés. En particulier, certaines caractéristiques et certains avantages du laser peuvent s'appliquer *mutatis mutandis* au procédé, et réciproquement.

## RESUME

Pour atteindre cet objectif, selon un mode de réalisation on prévoit un laser comprenant un miroir de Bragg distribué.

Le laser est destiné à émettre un rayonnement lumineux selon une direction longitudinale x et comprend un guide d'onde formé au moins en partie dans un empilement de couches à base de matériaux III-V. Ce guide d'onde comprend au moins une région active de l'empilement, ladite région active étant configurée pour émettre ledit rayonnement lumineux. L'au moins une région active est située à une profondeur $h_a$ mesurée selon la première direction transverse z depuis une face supérieure de l'empilement, la première direction transverse z étant perpendiculaire à la direction longitudinale x.

Le miroir de Bragg comprend des corrugations latérales disposées périodiquement selon x selon une période $\Lambda$. Ces corrugations latérales sont portées par au moins un flanc latéral du guide d'onde parallèle à un plan latéral xz défini par la direction longitudinale x et la première direction transverse z. Ces corrugations latérales présentent une hauteur h' selon la première direction transverse z et une dimension d selon une deuxième direction transverse y normale à la direction longitudinale x.

Le laser comprend en outre une électrode supérieure disposée sur la face supérieure du guide d'onde. Avantageusement, cette électrode supérieure comprend une partie supérieure couvrant la face supérieure du guide d'onde et au moins une partie latérale couvrant les corrugations latérales.

Avantageusement, les corrugations latérales du miroir de Bragg s'étendent depuis la face supérieure du guide d'onde et la hauteur h' est strictement inférieure à la profondeur $h_a$, de sorte qu'une partie de l'au moins un flanc latéral du guide d'onde soit dépourvue de corrugations latérales au niveau de l'au moins une région active. En particulier, les corrugations latérales ne s'étendent pas sur des flancs latéraux de la région active. La région active reste ainsi intacte sous l'électrode supérieure.

La région active d'un laser LCQ peut être décomposée en zones fonctionnelles distinctes : des zones d'émission de photons et des zones d'injection d'électrons. Structurellement, l'empilement de puits quantiques de la région active peut jouer le rôle d'un résonateur de Bragg, notamment au niveau des zones d'injection, pour les fonctions d'onde des électrons. Cela peut alors générer une bande interdite de faible amplitude entre les zones d'émission.

Dans le cadre du développement de la présente invention, il a été observé que la structuration DFB latérale de la région active selon l'art antérieur engendre des longueurs caractéristiques $\Lambda/2$ selon x dans la région active, pour chaque zone d'émission et chaque zone d'injection. Une telle dimension caractéristique est inférieure à la longueur de diffusion des électrons. Cela perturbe fortement l'injection des électrons, notamment au voisinage de la structuration DFB latérale. En particulier, les corrugations accroissent la surface développée des flancs latéraux de la région active. La passivation de ces flancs latéraux est imparfaite. La probabilité de recombinaisons non radiatives augmente donc, ceci d'autant plus que la largeur des corrugations est inférieure à la longueur de diffusion des électrons. Ces électrons ne participent donc pas à l'émission de lumière. L'efficacité d'injection est ainsi diminuée. Le seuil laser est augmenté. Par construction, il apparaît donc que la structuration DFB latérale de la région active rend l'injection des électrons inefficace.

Pour éviter de structurer latéralement la région active des lasers LCQ, la structuration DFB latérale est ici réalisée uniquement au niveau des couches supérieures de l'empilement, situées au-dessus de la région active. Cela permet de limiter significativement les pertes optiques du laser. Cela améliore également l'injection électrique dans la région active.

Pour améliorer la réflectivité du DFB, la période $\Lambda$ et la dimension d des corrugations latérales sont de préférence choisies telles que d/ $\Lambda$ > 1. Cela permet d'obtenir une rétroaction optique efficace. Une telle structuration DFB latérale permet en outre d'obtenir un bon contrôle du champ lointain et/ou du champ proche associés au rayonnement lumineux émis par le laser LCQ.

Le réflecteur de Bragg structuré latéralement au-dessus de la région active permet ainsi d'obtenir les performances optiques nécessaires au LCQ DFB tout en assurant une injection électrique améliorée. Les performances du laser sont ainsi améliorées.

Selon l'invention, le laser comprend en outre une électrode supérieure disposée sur la face supérieure du guide d'onde. L'injection électrique est ainsi améliorée.

Selon l'invention, l'électrode supérieure comprend une partie supérieure couvrant la face supérieure du guide d'onde et au moins une partie latérale couvrant les corrugations latérales. Ainsi, l'électrode est directement en contact avec les corrugations latérales. Les corrugations latérales sont à base de matériau semiconducteur. L'électrode est à base de matériau métallique. Cela permet de former une interface métal/semiconducteur entre l'électrode et les corrugations latérales. Une telle interface améliore l'efficacité de rétroaction optique des corrugations latérales. La réflectivité du DFB est ainsi augmentée. La surface de contact entre l'électrode et le guide d'onde est augmentée. L'injection électronique est ainsi améliorée.

Selon un autre aspect on prévoit un procédé de formation d'un laser comprenant un miroir de Bragg distribué. Ce procédé comprend :

- Une fourniture d'un empilement de couches à base de matériaux III-V comprenant au moins une région active destinée à émettre un rayonnement lumineux,
- Une formation d'un motif de guide d'onde dans l'empilement de couches, ledit motif de guide d'onde présentant une longueur L selon une direction longitudinale x, une hauteur h selon une première direction transverse z et une largeur w selon une deuxième direction transverse y, les première et deuxième directions transverses z, y étant normales à la direction longitudinale x, ledit motif de guide d'onde présentant une face supérieure et des flancs latéraux s'étendant parallèlement à un plan latéral xz défini par la direction longitudinale x et la première direction transverse z,
- Une structuration dudit motif de guide d'onde de sorte à former des corrugations latérales au niveau desdits flancs latéraux, lesdites corrugations latérales étant périodiques de période $\Lambda$ selon la direction longitudinale x et présentant une dimension d selon la deuxième direction transverse y, et formant au moins en partie le miroir de Bragg distribué.

Avantageusement, ladite structuration est configurée de façon à ce que les corrugations latérales du miroir de Bragg s'étendent depuis la face supérieure du motif de guide d'onde selon la première direction transverse z sur une hauteur h' strictement inférieure à une profondeur $h_a$ à laquelle est située l'au moins une région active en partant de la face supérieure du motif de guide d'onde, tel qu'une partie des flancs latéraux du guide d'onde soit dépourvue de corrugations latérales au niveau de l'au moins une région active.

Le procédé comprend en outre une formation d'un motif d'électrode supérieure au moins en partie sur la face supérieure du motif de guide d'onde. La formation du motif d'électrode supérieure comprend un dépôt d'une couche métallique sur la face supérieure et sur les corrugations latérales, et une structuration de ladite couche métallique de sorte que ledit motif d'électrode supérieure présente une partie supérieure couvrant la face supérieure du guide d'onde et au moins une partie latérale couvrant les corrugations latérales.

Ce procédé permet typiquement de réaliser des lasers tels que décrits plus hauts et présentant des performances améliorées. Ce procédé est en outre typiquement basé sur une filière technologique silicium avantageusement compatible avec une chaîne de fabrication dite CMOS (fabrication de transistors métal-oxyde-semiconducteur complémentaires).

## BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

La figure 1 illustre schématiquement un laser DFB à structuration latérale selon l'art antérieur.

La figure 2A illustre schématiquement un guide d'onde de laser DFB structuré latéralement selon un mode de réalisation de la présente invention.

La figure 2B illustre schématiquement en coupe transverse le guide d'onde de laser DFB structuré latéralement illustré à la figure 2A, selon un mode de réalisation de la présente invention.

La figure 3A illustre la réflectivité d'un réflecteur de Bragg distribué à structuration latérale pour différents ratios d/$\Lambda$, pour une hauteur de corrugations latérales h' = 1,2 $\mu$m et pour une largeur de guide d'onde w = 6 $\mu$m, selon un mode de réalisation de la présente invention.

La figure 3B illustre la réflectivité d'un réflecteur de Bragg distribué à structuration latérale pour différents ratios d/$\Lambda$, pour une hauteur de corrugations latérales h' = 1,2 $\mu$m et pour une largeur de guide d'onde w = 8 $\mu$m, selon un mode de réalisation de la présente invention.

La figure 3C illustre la réflectivité d'un réflecteur de Bragg distribué à structuration latérale pour différents ratios d/$\Lambda$, pour une hauteur de corrugations latérales h' = 1,2 $\mu$m et pour une largeur de guide d'onde w = 10 $\mu$m, selon un mode de réalisation de la présente invention.

La figure 4A illustre la distribution en champ lointain de l'intensité émise par un laser sans structuration DFB latérale.

La figure 4B illustre la distribution en champ lointain de l'intensité émise par un laser avec structuration DFB latérale, selon un mode de réalisation de la présente invention.

La figure 5A illustre schématiquement un laser DFB à structuration latérale selon un premier mode de réalisation qui n'est pas couvert par la présente invention.

La figure 5B illustre schématiquement un laser DFB à structuration latérale selon un deuxième mode de réalisation de la présente invention.

La figure 5C illustre schématiquement un laser DFB à structuration latérale selon un troisième mode de réalisation de la présente invention.

La figure 6A illustre la réflectivité d'un réflecteur de Bragg distribué à structuration latérale pour différents ratios $d/\Lambda$ et pour une hauteur de corrugations latérales h' = 1,2 $\mu$m, sans couverture métallique desdites corrugations latérales, selon un mode de réalisation de la présente invention.

La figure 6B illustre la réflectivité d'un réflecteur de Bragg distribué à structuration latérale pour différents ratios $d/\Lambda$ et pour une hauteur de corrugations latérales h' = 500 nm, sans couverture métallique desdites corrugations latérales, selon un mode de réalisation de la présente invention.

La figure 6C illustre la réflectivité d'un réflecteur de Bragg distribué à structuration latérale pour différents ratios $d/\Lambda$ et pour une hauteur de corrugations latérales h' = 500 nm, avec couverture métallique desdites corrugations latérales, selon un mode de réalisation de la présente invention.

Les figures 7A à 7H illustrent schématiquement en coupe transverse des étapes d'un procédé de fabrication d'un laser DFB à structuration latérale selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des corrugations et des motifs ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :

Selon un exemple, les corrugations latérales du miroir de Bragg sont distribuées et dimensionnées de sorte que $d/\Lambda$ > 1. Cela permet d'augmenter la réflectivité du DFB. Cela permet d'éviter une dégradation de la distribution d'intensité en champ lointain du rayonnement lumineux. En particulier, la divergence du rayonnement lumineux est ainsi réduite. Le fait que les corrugations latérales ne s'étendent pas jusqu'à la région active diminue également la divergence du faisceau formé par le rayonnement lumineux. Le faisceau est donc moins divergent dans un tel guide d'onde, toutes choses étant égales par ailleurs, que dans un guide d'onde d'un laser selon l'art antérieur.

Selon un exemple, l'empilement de couches comprend au moins une couche de confinement optique, dite LOC, de préférence à base d'InGaAs et située au-dessus de l'au moins une région active, à une profondeur $h_c$ selon la première direction transverse z depuis la face supérieure.

Selon un exemple, les corrugations latérales du miroir de Bragg s'étendent depuis la face supérieure sur une hauteur h' strictement inférieure à $h_c$ telle que la partie de l'au moins un flanc latéral du guide d'onde soit dépourvue de corrugations latérales au niveau de ladite couche de confinement optique. Cela permet de réduire significativement les pertes optiques.

Selon un exemple, les corrugations latérales sont distantes de l'au moins une région active d'une distance $h_a$ - h' selon la première direction transverse z, $h_a$ - h' étant supérieure ou égale à 200 nm. Cela permet de réduire significativement les pertes optiques.

Selon un exemple, la hauteur h' des corrugations latérales du miroir de Bragg est supérieure ou égale à 500 nm, par exemple de l'ordre de 1 $\mu$m ou 1,2 $\mu$m. Cela permet d'obtenir une bonne réflectivité du DFB.

Selon un exemple, l'au moins une partie latérale de l'électrode supérieure présente des corrugations métalliques couvrant les corrugations latérales du miroir de Bragg. Ainsi, l'électrode supérieure est elle-même structurée de façon à présenter également des corrugations métalliques. La réflectivité du DFB est encore plus augmentée. L'injection électronique est également améliorée.

Selon un exemple, le guide d'onde présente une hauteur h inférieure ou égale à 4 $\mu$m. Cela permet d'améliorer l'efficacité de réflexion optique du réflecteur de Bragg latéral. Cette valeur de hauteur h peut être optimisée en fonction de la longueur d'onde d'émission, de la largeur de guide et de l'empilement de couches à base de matériaux III-V.

Selon un exemple, le guide d'onde présente une largeur w inférieure ou égale à 10 $\mu$m, par exemple de l'ordre de 6 $\mu$m ou 8 $\mu$m. Cela permet de limiter le nombre de modes optiques se propageant dans le guide d'onde. Avantageusement, seul le mode fondamental du rayonnement lumineux se propage au sein du guide d'onde. L'efficacité du laser est ainsi améliorée.

Selon un exemple, le laser est un laser à cascade quantique.

Selon un exemple, l'empilement comprend une couche d'arrêt située au-dessus de l'au moins une région active, et la structuration des corrugations latérales est configurée de façon à ce que les corrugations latérales ne s'étendent pas au-delà de ladite couche d'arrêt selon la première direction transverse z, ladite couche d'arrêt étant située à une profondeur sensiblement égale à h' par rapport à la face supérieure du motif de guide d'onde. Cela permet de protéger l'au moins une région active lors de la structuration ou de la formation des corrugations latérales, typiquement par gravure. Cela permet notamment de contrôler plus précisément une profondeur de gravure lors de la formation des corrugations latérales par gravure. La hauteur h' des corrugations latérales est ainsi précisément définie.

Selon un exemple, la couche d'arrêt est à base d'InGaAs et présente une épaisseur e' comprise entre 20 nm et 200 nm. Une couche d'arrêt à base d'InGaAs présente typiquement un indice de réfraction suffisamment bas pour des applications laser. Elle est de préférence dopée, de manière à permettre le transfert des porteurs lors du fonctionnement du laser. L'épaisseur e' est de préférence inférieure à une épaisseur critique définissant un domaine de relaxation plastique. Cela permet d'obtenir une couche d'arrêt pseudo-morphique. Selon un exemple, la couche d'arrêt est pseudomorphique.

Selon l'invention, le procédé comprend en outre une formation d'un motif d'électrode supérieure au moins en partie sur la face supérieure du motif de guide d'onde.

Selon l'invention, la formation du motif d'électrode supérieure comprend un dépôt d'une couche métallique sur la face supérieure et sur les corrugations latérales, et une structuration de ladite couche métallique de sorte que ledit motif d'électrode supérieure présente une partie supérieure couvrant la face supérieure du guide d'onde et au moins une partie latérale couvrant les corrugations latérales.

Selon un exemple, la structuration de la couche métallique est configurée de sorte à ce que l'au moins une partie latérale du motif d'électrode présente des flancs latéraux parallèles au plan latéral xz et exempts de corrugations latérales.

Selon un exemple alternatif, la structuration de la couche métallique est configurée de sorte à ce que l'au moins une partie latérale du motif d'électrode présente des corrugations métalliques couvrant les corrugations latérales.

Sauf incompatibilité, il est entendu que le procédé de fabrication et le laser peuvent comprendre, *mutatis mutandis,* l'ensemble des caractéristiques optionnelles ci-dessus.

Dans le cadre de la présente invention, les locutions « miroir de Bragg », « réseau de Bragg » ou « réflecteur de Bragg distribué » ou encore « DFB (Distributed FeedBack) » sont employées en synonymes. Le miroir de Bragg est ici configuré pour être utilisé comme réflecteur pour un guide d'onde. Il comprend une alternance périodique de matériaux d'indices de réfraction différents. Cette alternance induit une variation périodique de l'indice de réfraction effectif dans le guide d'onde. Une telle alternance est reproduite au moins deux fois dans le cadre d'un miroir de Bragg selon la présente invention.

Cette alternance est typiquement produite par des corrugations latérales. Les corrugations latérales désignent des éléments en saillie vis-à-vis d'un plan latéral. Elles peuvent présenter différents profils en projection dans un plan xy, par exemple et de façon non limitative : un profil en créneau tel qu'illustré dans les dessins d'accompagnement, un profil sinusoïdal ou triangulaire.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage indiqués dans la présente demande sont les suivantes :

- dopage p++ ou n++ : supérieur à $1 \times 10^{20}$cm$^{-3}$
- dopage p+ ou n+ : $1 \times 10^{18}$ cm$^{-3}$ à $9 \times 10^{19}$ cm$^{-3}$
- dopage p ou n : $1 \times 10^{17}$ cm$^{-3}$ à $1 \times 10^{18}$ cm$^{-3}$
- dopage intrinsèque : $1.10^{15}$ cm$^{-3}$ à $1.10^{17}$ cm$^{-3}$

Les exemples de réalisation décrits dans la suite indiquent un dopage de type n. D'autres modes de réalisation, dans lesquels un dopage de type p est réalisé, peuvent également être envisagés. Ainsi, des lasers QCL pour lesquels les porteurs de charge sont des trous peuvent également être réalisés selon la présente invention.

Le domaine du moyen infrarouge (MIR) comprend typiquement des longueurs d'onde $\lambda$ entre 3 $\mu$m et 12 $\mu$m. Un exemple de mise en oeuvre du procédé est donné pour la réalisation d'un laser LCQ DFB émettant à une longueur d'onde de 7,4 $\mu$m. Le miroir de Bragg présente typiquement un pic de réflectivité centré sur la longueur d'onde $\lambda$.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche de l'empilement présente typiquement une épaisseur selon z. La hauteur et la profondeur sont prises selon z. Les termes relatifs « sur », « surmonte », « sous », « sous-jacent », « au-dessus » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz. Ainsi, des corrugations latérales sont portées par un plan xz. Une structuration latérale est effectuée au niveau d'un plan xz.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

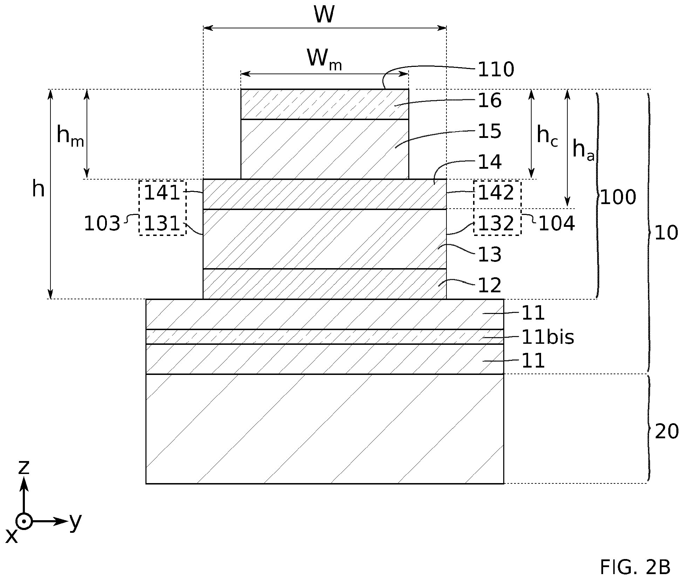

Un premier exemple de laser selon l'invention est illustré aux figures 2A, 2B. Dans cet exemple, un guide d'onde 100 à base de matériaux III-V est formé sur un substrat 20. Ce guide d'onde 100 comprend au moins une région active 13 destinée à émettre un rayonnement lumineux de longueur d'onde $\lambda$. Avantageusement, le laser comprend un DFB latéral formé dans une partie supérieure du guide d'onde, ladite partie supérieure étant située au-dessus de la région active 13, selon z.

Le guide d'onde 100 présente typiquement une longueur L selon x, une largeur w selon y et une hauteur h selon z. La longueur L est typiquement de l'ordre de quelques centaines de microns à quelques millimètres, par exemple comprise entre 500 $\mu$m et 4 mm, voire 6 mm. On choisira par exemple de préférence L=1 mm ou L=2 mm. La largeur w est de l'ordre de quelques microns, par exemple comprise entre 4 $\mu$m et 10 $\mu$m, par exemple w=8 $\mu$m. La hauteur h est typiquement de l'ordre de quelques microns, par exemple comprise entre 1 $\mu$m et 10 $\mu$m, par exemple h=5 $\mu$m. Comme le DFB est formé latéralement sur les flancs du guide d'onde, en partie supérieure du guide d'onde 100, le mode optique de propagation du rayonnement lumineux présente un bon couplage avec le réseau DFB.

Le guide d'onde 100 peut être un guide d'onde en ruban présentant une section transverse rectangulaire, ou un guide d'onde en arête présentant une section transverse en T inversé. Dans le cas d'un guide d'onde en arête, la partie supérieure du guide se présente typiquement sous forme d'un mésa s'étendant longitudinalement, de longueur L, de largeur $w_m < w$ et de hauteur $h_m < h$. La largeur $w_m$ peut être de l'ordre de 50% à 80% de la largeur w. La hauteur hm est typiquement de l'ordre de quelques centaines de nanomètres à quelques microns, par exemple comprise entre 500 nm et 6 $\mu$m. La face supérieure 110 du guide d'onde 100 est prise au sommet du mésa. D'autres géométries de guide d'onde sont également possibles.

Le guide d'onde 100 peut être formé à partir d'une vignette comprenant un empilement 10 de couches 11, 11 bis, 12, 13, 14, 15, 16 à base de matériaux III-V, reportée sur un substrat à base de silicium. Ce report peut typiquement se faire par collage moléculaire. La vignette peut se présenter sous forme d'un substrat InP de deux pouces sur lequel est formé l'empilement 10. Le substrat comprend ainsi typiquement une partie 20 en silicium et éventuellement une partie en InP et/ou quelques couches de l'empilement 10. Le substrat InP peut être aminci ou retiré partiellement ou en totalité lors du report, avant ou après collage. Le guide d'onde 100 est formé dans l'empilement 10.

L'empilement 10 comprend typiquement une pluralité de couches destinées à l'injection des électrons, à l'émission du rayonnement lumineux, au guidage du rayonnement lumineux.

Selon une possibilité, l'empilement 10 peut comprendre, depuis l'interface de collage jusqu'à la surface supérieure 110 de l'empilement selon z :

- une couche 11 à base d'InP dopée n+ ou n++, présentant une épaisseur comprise entre 1,5 $\mu$m et 5 $\mu$m.
- Une couche 11 bis d'InGaAs dopée n+ ou n++ de 100 nm à 300 nm peut être avantageusement intercalée au sein de la couche 11 d'InP n+ ou n++ mentionnée ci-dessus. Cette couche 11 bis d'InGaAs n++ se trouve de préférence à une profondeur comprise entre 1 $\mu$m et 3 $\mu$m, idéalement entre 1,5 $\mu$m et 2 $\mu$m, de la face supérieure de la couche 11 d'InP n+ ou n++. Cette couche 11 bis d'InGaAs dopée présente typiquement un niveau de dopage supérieur d'au moins un facteur 10 au niveau de dopage de la couche 11 InP n+ ou n++ mentionnée ci-dessus.

- une couche 12 à base d'InGaAs dite LOC, présentant une épaisseur comprise entre 20 nm et 200 nm.
- une région active 13 présentant une épaisseur comprise entre 1,5 $\mu$m et 4 $\mu$m. La région active est située à une hauteur ha selon z en partant de la face supérieure 110.
- une couche 14 à base d'InGaAs dite LOC, présentant une épaisseur comprise entre 20 nm et 200 nm. La couche 14 LOC est située à une hauteur hc selon z en partant de la face supérieure 110.
- une couche 15 à base d'InP, présentant une épaisseur comprise entre1 $\mu$m et 3 $\mu$m, et un faible niveau de dopage.
- une couche 16 à base d'InGaAs dopée n+ ou n++, présentant une épaisseur comprise entre 20 nm et 100 nm. Cette couche d'InGaAs dopée présente typiquement un niveau de dopage supérieur d'au moins un facteur 10 au niveau de dopage de la couche InP sous-jacente.

Les couches dopées n+ ou n++ participent typiquement à l'injection des électrons au sein de la région active. Les couches 12, 14 LOC permettent typiquement de confiner le rayonnement lumineux au niveau de la région active. Elles présentent typiquement un faible indice de réfraction, par exemple de l'ordre de 3,17 pour une longueur d'onde $\lambda$ de l'ordre de 7,4 $\mu$m, et sont appelées couches de guidage. Le faible niveau de dopage de la couche 15 InP permet de limiter les pertes optiques. L'épaisseur relativement grande de cette couche 15 InP permet une répartition homogène de l'injection des électrons dans toute la région active.

La région active 13 comprend typiquement une multitude de puits quantiques dans lesquels les électrons vont transiter en cascade, en émettant un rayonnement lumineux. Selon une possibilité, la région active 13 peut comprendre des couches d'InGaAs et d'AlInAs alternées. Le lecteur peut se référer au document « Carras, M. et al. Top grating index-coupled distributed feedback quantum cascade lasers. Appl. Phys. Lett. 93, 011109 (2008) » pour la conception de la région active, en particulier pour le choix des hétérostructures d'InGaAs/d'AlInAs, le nombre de périodes et/ou de puits quantiques, et l'architecture de super-réseau résonnant.

Dans le cas d'un guide d'onde en arête, le mésa peut typiquement être formé au niveau des deux couches supérieures de l'empilement 10, la couche 15 d'InP et la couche 16 d'InGaAs dopée n+ ou n++.

Avantageusement, une partie de l'empilement 10, située au-dessus de la région active 13, est structurée au niveau de ses flancs latéraux 101, 102 de façon à former un réflecteur de Bragg distribué ou DFB latéral. Le guide d'onde 100 présente ainsi typiquement des corrugations 56 sur les flancs latéraux 101, 102. Ces corrugations 56 sont réparties régulièrement selon x selon une période $\Lambda$. La période $\Lambda$ est de préférence choisie telle que $\Lambda = m.\lambda/2n$, $\lambda$ étant la longueur d'onde du rayonnement lumineux, n étant l'indice de réfraction effectif du mode optique de propagation du rayonnement lumineux, et m l'ordre du réseau du réflecteur de Bragg. L'ensemble des corrugations latérales forment le DFB latéral de longueur L' et de hauteur h'.

Les corrugations 56 sont disposées de part et d'autre des flancs 101, 102, en vis-à-vis selon y. Elles présentent chacune une dimension d selon y et une dimension I selon x. Avantageusement, les corrugations 56 présentent une hauteur h' < $h_a$, de sorte qu'elles s'étendent uniquement dans la partie supérieure de l'empilement 10. Les flancs latéraux 131, 132 de la région active 13 sont ainsi dépourvus de corrugations latérales. Cela permet de limiter les pertes optiques du laser. Selon une possibilité, les corrugations 56 présentent une hauteur h' < $h_c$. Les flancs latéraux 141, 142 de la couche 14 LOC sont ainsi dépourvus de corrugations latérales. Cela réduit encore les pertes optiques du laser. Selon une possibilité, la hauteur h' des corrugations latérales est égale à la hauteur $h_m$ du mésa. La hauteur h' des corrugations latérales est de préférence supérieure ou égale à 500 nm, par exemple de l'ordre de 1 $\mu$m ou de 2 $\mu$m.

La dimension d est de l'ordre de quelques microns, par exemple 1,5 $\mu$m. La dimension I est par exemple égale à une demi-période $\Lambda/2$. La largeur hors tout du DFB, incluant les corrugations 56 est de préférence égale à la largeur du sommet du guide d'onde 100, w ou $w_m$. Ainsi, la partie supérieure du guide d'onde structurée latéralement en DFB peut présenter une alternance de parties étroites de largeur 5 $\mu$m et de parties larges, au niveau des corrugations 56, de largeur 8 $\mu$m par exemple. La modulation de largeur selon y est avantageusement choisie telle que $d/\Lambda \geq 1$. Selon un exemple, la période $\Lambda$ et la dimension d sont choisies telles que $d/\Lambda = 1,5$. Selon un autre exemple, la période $\Lambda$ et la dimension d sont choisies telles que $d/\Lambda = 2$. Cela permet d'améliorer la force de couplage du réseau de Bragg. La réflectivité du DFB est augmentée.

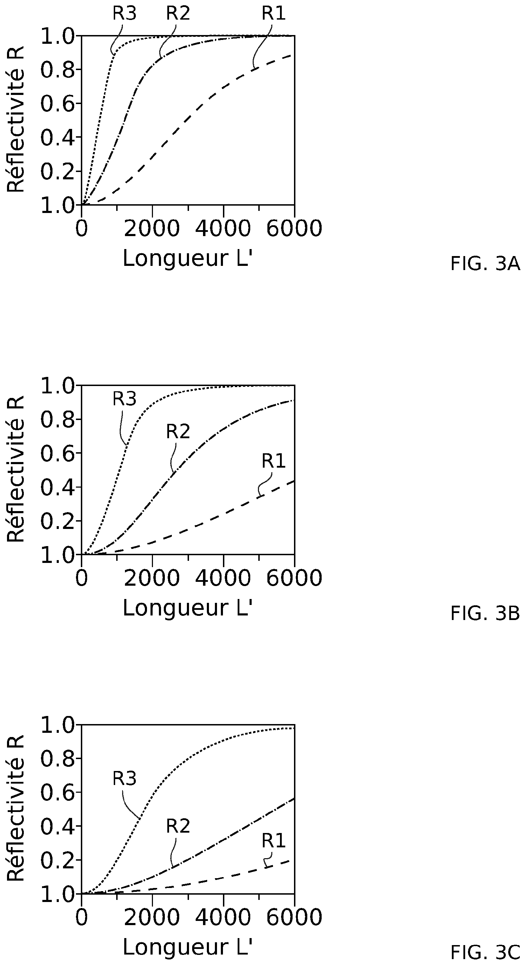

Les figures 3A à 3C illustrent des courbes de réflectivité simulées en fonction de la longueur L' du DFB pour une hauteur h' de corrugations latérales de 1,2 $\mu$m. Les courbes R1, R2, R3 correspondent à différents ratios $d/\Lambda$. En particulier, la courbe R1 correspond à un ratio $d/\Lambda = 0,42$ (d = 500 nm), la courbe R2 correspond à un ratio $d/\Lambda = 0,85$ (d = 1 $\mu$m), la courbe R3 correspond à un ratio $d/\Lambda = 1,71$ (d = 2 $\mu$m). Pour ces simulations, le guide d'onde présente une architecture en mésa. Le mésa est formé au niveau des couches 15, 16. Les corrugations latérales s'étendent sur toute la hauteur du mésa de sorte que h' = $h_m$ = $h_c$. Les corrugations latérales ne s'étendent pas dans la couche 14 de confinement optique.

Les simulations sont effectuées pour une demi-cavité de longueur L'/2 et pour différentes largeur de guide d'onde, en particulier pour w = 6 $\mu$m (figure 3A), pour w = 8 $\mu$m (figure 3B), pour w = 10 $\mu$m (figure 3C).

Il apparaît que la réflectivité R(L') est d'autant plus élevée que la largeur w du guide est faible, pour une longueur de DFB L' donnée et pour un ratio $d/\Lambda$ fixé. Le couplage entre le mode optique de propagation du rayonnement lumineux et le DFB latéral est d'autant meilleur que la largeur w du guide est faible. En outre, pour une longueur de DFB L' donnée et pour une largeur w fixée, il apparaît que la réflectivité R(L') est d'autant plus élevée que le ratio d/Λ est élevé. On choisira ainsi de préférence un guide d'onde de largeur inférieure ou égale à 10 μm et de ratio d/Λ supérieur ou égal à 1, et plus préférentiellement une largeur inférieure ou égale à 8 μm et un ratio d/Λ strictement supérieur à 1. Cela permet de dimensionner des DFB latéraux de longueur L' raisonnable, typiquement inférieure à 3 mm, et présentant une bonne réflectivité R, typiquement supérieure à 95%. De telles dimensions de DFB sont parfaitement compatibles avec les lasers LCQ cités plus haut.

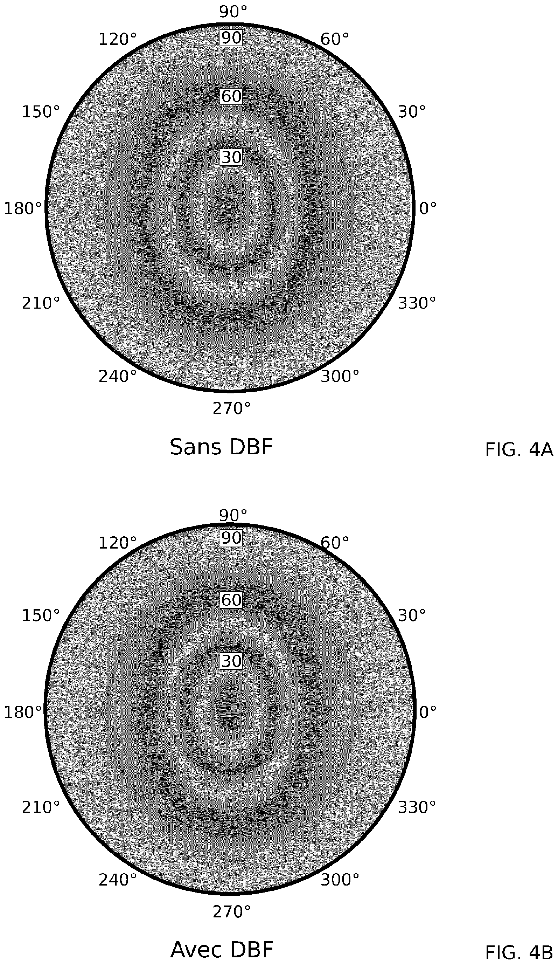

En outre, de tels DFB latéraux modifient peu la distribution d'intensité en champ proche et/ou en champ lointain du rayonnement lumineux. Les figures 4A, 4B illustrent un exemple comparatif de distributions d'intensité simulées en champ lointain, pour un guide d'onde de largeur w = 8 μm, sans DFB (figure 4A) et avec un DFB latéral de ratio d/Λ = 1,5 (figure 4B). Ces distributions sont très similaires. Le DFB latéral n'impacte pas ou quasiment pas la distribution d'intensité en champ lointain. Ceci est particulièrement avantageux pour le couplage des lasers comprenant ces DFB latéraux avec d'autres composants optiques.

La distribution d'intensité du rayonnement lumineux en champ lointain varie en fonction du ratio d/Λ, selon la direction z perpendiculaire aux couches de l'empilement, et selon la direction y parallèle aux couches de l'empilement. Cette variation reste cependant faible. La divergence du rayonnement lumineux selon z est ainsi réduite, comme illustré au tableau 1. La divergence du rayonnement lumineux selon y est également réduite, comme illustré au tableau 2. Elle est par exemple de l'ordre de 1,2 % dans le cas où d/Λ=2 pour un guide de largeur de 6 μm.

| Réduction de la divergence selon z, par rapport à un guide d'onde sans DFB (%) | $\frac{d}{\Lambda} = 1$ | $\frac{d}{\Lambda} = 1.5$ | $\frac{d}{\Lambda} = 2$ |
|---|---|---|---|
| Largeur du guide w = 6 μm | 0,12 | 0,22 | 0,34 |
| Largeur du guide w = 8 μm | 0,15 | 0,24 | 0,34 |
| Largeur du guide w = 10 μm | 0,10 | 0,15 | 0,24 |

| Réduction de la divergence selon y, par rapport à un guide d'onde sans DFB (%) | $\frac{d}{\Lambda} = 1$ | $\frac{d}{\Lambda} = 1.5$ | $\frac{d}{\Lambda} = 2$ |
|---|---|---|---|
| Largeur du guide w = 6 μm | 0,72 | 1,00 | 1,21 |
| Largeur du guide w = 8 μm | 0,53 | 0,77 | 0,94 |
| Largeur du guide w = 10 μm | 0,37 | 0,51 | 0,65 |

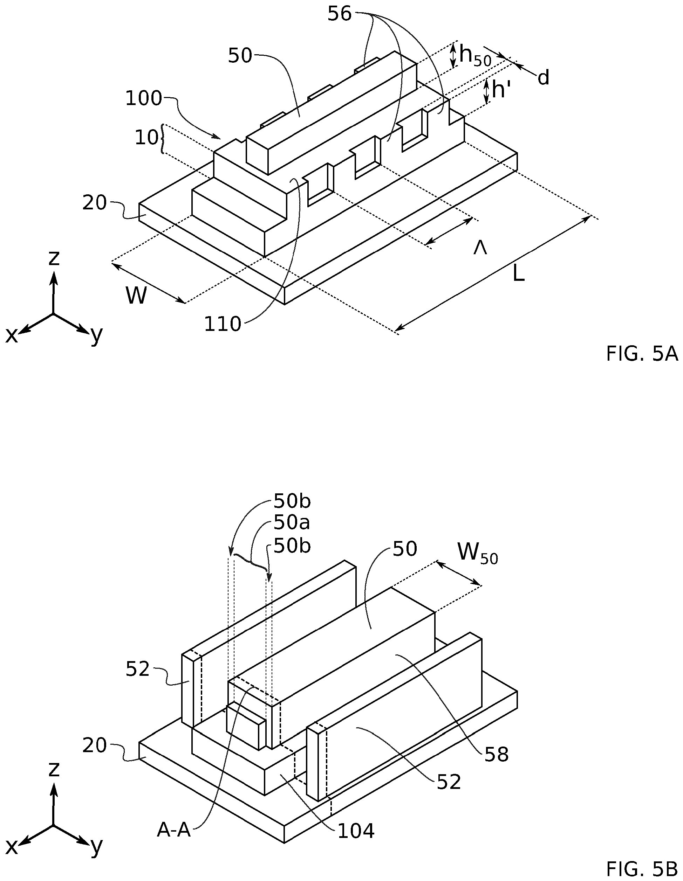

Comme illustré aux figures 5A-5C, une électrode supérieure 50 est formée sur la partie supérieure du guide d'onde 100. Elle est à base de matériau métallique. Elle est par exemple constituée d'une ou plusieurs couches à base d'or, et/ou de titane, et/ou de nitrure de titane, et/ou d'alliage aluminium-cuivre, et/ou de tungstène.

Selon un mode de réalisation non couvert par l'invention et illustré à la figure 5A, l'électrode supérieure 50 est formée uniquement sur la face supérieure 110 du guide d'onde. Elle présente typiquement une hauteur hso selon z, de préférence comprise entre 1 μm et 3 μm.

Selon un autre mode de réalisation couvert par l'invention et illustré à la figure 5B, l'électrode supérieure 50 comprend une partie centrale également appelée partie supérieure 50a située sur la face supérieure 110 de l'empilement, et des parties latérales 50b situées de part et d'autre de la partie centrale 50a, et couvrant les corrugations latérales du DFB. Les parties latérales 50b remplissent les espaces entre les corrugations latérales. Elles couvrent de préférence entièrement les corrugations latérales. Elles peuvent prendre appui sur la partie inférieure du guide d'onde, de part et d'autre du mésa. Dans cet exemple, les parties latérales 50b présentent des flancs latéraux 58 selon xz sensiblement plans. La partie centrale 50a présente typiquement une hauteur $h_{50}$ selon z, et les parties latérales 50b présentent typiquement une hauteur $h_{50}$ + h' selon z. L'électrode 50 présente une largeur $w_{50}$ supérieure à la largeur $w_m$ du mésa. Une telle électrode 50 permet d'améliorer l'efficacité du DFB. La réflectivité du DFB latéral est augmentée en présence des parties latérales 50b de l'électrode 50. L'injection électronique via cette électrode 50 est également améliorée.

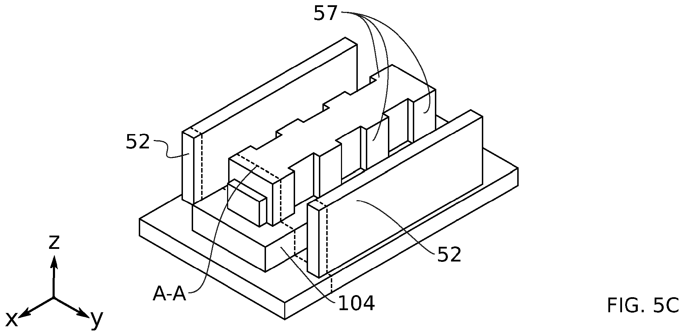

Selon un autre mode de réalisation couvert par l'invention et illustré à la figure 5C, l'électrode supérieure 50 couvre également la face supérieure et les corrugations latérales, comme dans le mode de réalisation précédent. Dans cet exemple, les flancs latéraux des parties latérales 50b ne sont pas plans. Les parties latérales 50b de l'électrode 50 présentent le même type de corrugations latérales que le DFB. Les corrugations 57 de l'électrode 50 peuvent suivre de façon conforme ou quasiment conforme les corrugations latérales du DFB. Cela permet d'améliorer encore plus l'efficacité du DFB, en particulier si l'épaisseur selon y des corrugations 57 est inférieure ou égale à 20 nm. L'injection électronique via cette électrode 50 est également améliorée.

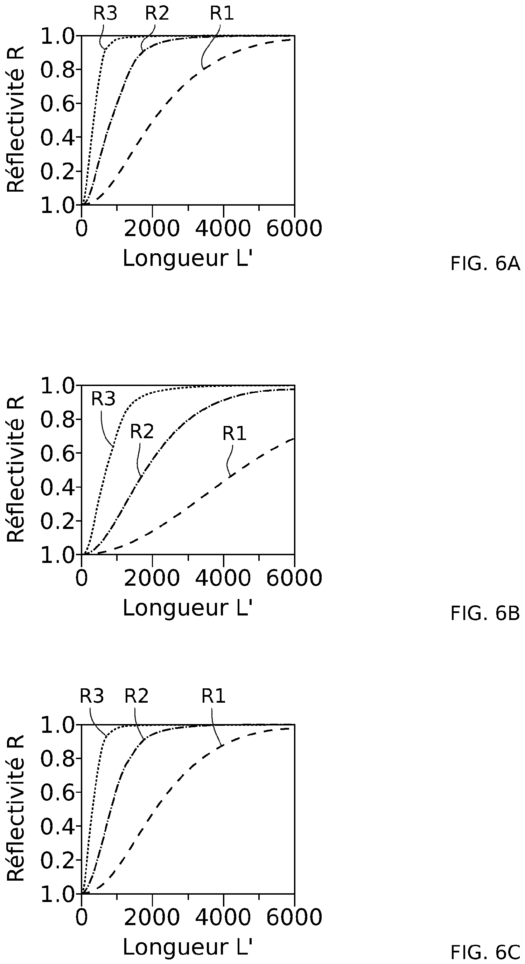

Les figures 6A à 6C illustrent des courbes de réflectivité simulées en fonction de la longueur L' du DFB pour une largeur w de guide d'onde de 6 $\mu$m. Les courbes R1, R2, R3 correspondent à différents ratios d/$\Lambda$. En particulier, la courbe R1 correspond à un ratio d/$\Lambda$ = 0,42 (d = 500 nm), la courbe R2 correspond à un ratio d/$\Lambda$ = 0,85 (d = 1 $\mu$m), la courbe R3 correspond à un ratio d/$\Lambda$ = 1,71 (d = 2 $\mu$m).

Les simulations sont effectuées pour différentes configurations de DFB et d'électrode. La figure 6A présentent les courbes R1, R2, R3 obtenues pour des corrugations de hauteur h' = 1,2 $\mu$m, sans électrode latérale couvrant le DFB. La figure 6B présentent les courbes R1, R2, R3 obtenues pour des corrugations de hauteur h' = 500 nm, sans électrode latérale couvrant le DFB. La figure 6C présentent les courbes R1, R2, R3 obtenues pour des corrugations de hauteur h' = 500 nm, avec une électrode métallique latérale couvrant le DFB.

Une réflectivité R(L') élevée peut être atteinte dans le cas où le ratio d/$\Lambda$ est supérieur à 1, en particulier lorsque la hauteur des corrugations latérales est grande (figure 6A).

En diminuant la hauteur des corrugations, la réflectivité diminue (figure 6B). La présence de l'électrode métallique sur les corrugations latérales du DFB permet d'augmenter la réflectivité, même lorsque la hauteur des corrugations est petite (figure 6C).

Ainsi, des guides d'onde de largeur inférieure à 8 $\mu$m avec des DFB présentant un ratio d/$\Lambda$>1 sont de bons candidats pour des lasers LCQ efficaces, en particulier quand les corrugations latérales des DFB sont recouvertes par du métal, comme illustré pour les modes de réalisation des figures 5B, 5C.

Le laser selon la présente invention, comprenant un DFB latéral formé en partie supérieure du guide d'onde, sans corrugations latérales au niveau des flancs de la région active, peut avantageusement être intégré dans un capteur environnemental fonctionnant dans le moyen infrarouge.

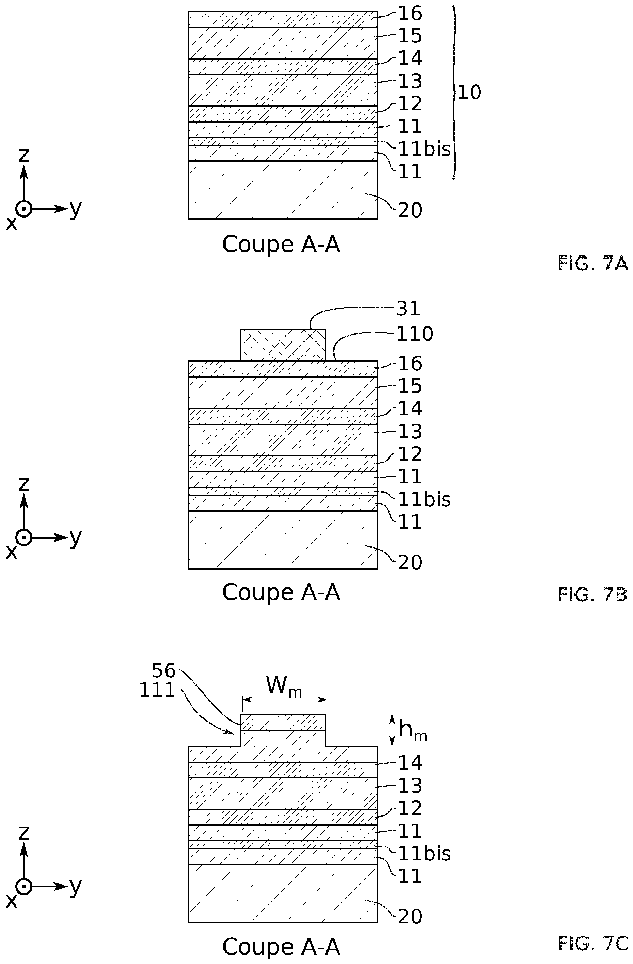

Les figures 7A à 7H illustrent un mode de réalisation d'un procédé de réalisation d'un tel laser.

Un empilement 10 de couches 11, 11 bis, 12, 13, 14, 15, 16 portées par un substrat 20 est d'abord fourni (figure 7A). Comme décrit précédemment, le substrat 20 peut être en silicium. L'empilement 10 comprend des couches à base de matériaux III-V, notamment :

- une couche 11 à base d'InP dopée n+ ou n++, présentant une épaisseur comprise entre 1,5 $\mu$m et 5 $\mu$m,
- une couche 11 bis d'InGaAs dopée n+ ou n++ de 100 nm à 300 nm peut être avantageusement intercalée au sein de la couche 11 d'InP n+ ou n++ mentionnée ci-dessus. Cette couche 11 bis d'InGaAs n++ se trouve de préférence à une profondeur comprise entre 1 $\mu$m et 3 $\mu$m, idéalement entre 1,5 $\mu$m et 2 $\mu$m, de la face supérieure de la couche 11 d'InP n+ ou n++. Cette couche 11 bis d'InGaAs dopée présente typiquement un niveau de dopage supérieur d'au moins un facteur 10 au niveau de dopage de la couche 11 InP n+ ou n++ mentionnée ci-dessus.
- une couche 12 à base d'InGaAs dite LOC, présentant une épaisseur comprise entre 20 nm et 200 nm,
- une région active 13 comprenant des puits quantiques et présentant une épaisseur comprise entre 1,5 $\mu$m et 4 $\mu$m,
- une couche 14 à base d'InGaAs dite LOC, présentant une épaisseur comprise entre 20 nm et 200 nm,
- une couche 15 à base d'InP, présentant une épaisseur comprise entre1 $\mu$m et 3 $\mu$m,
- une couche 16 à base d'InGaAs dopée n+ ou n++, présentant une épaisseur comprise entre 20 nm et 100 nm.

Dans cet exemple de réalisation, le guide d'onde formé est un guide en arête comprenant une structure supérieure en mésa. La structure en mésa forme ici la partie supérieure du guide d'onde comprenant les corrugations latérales. Les corrugations latérales sont ici formées directement au niveau des flancs latéraux de cette structure supérieure en mésa. Ainsi, comme illustré aux figures 7B, 7C, une première lithographie/gravure est effectuée de façon à former cette structure 111 supérieure en mésa, pourvue de corrugations latérales 56. La figure 7B illustre la formation d'un masque 31 de lithographie à base de résine photosensible permettant de définir la structure en mésa de largeur w$_m$. Le masque 31 en résine est structuré latéralement, typiquement par lithographie UV profond, de façon à définir un motif de corrugations latérales au-dessus de la couche 16. La figure 7C illustre la gravure des couches 16 et 15 sur une profondeur h$_m$, avec arrêt dans la couche 15 d'InP. Les corrugations latérales présentent ici de préférence une hauteur h' = h$_m$.

Selon une possibilité, une couche d'arrêt de gravure à base d'InGaAs de quelques dizaines de nanomètres est prévue dans l'empilement, au sein de la couche 15, à une profondeur h' depuis la face supérieure 110 (non illustré). Une telle couche d'arrêt peut être typiquement pseudomorphe. Elle permet avantageusement d'arrêter la gravure des couches 16, 15 de façon à obtenir précisément la hauteur h' de corrugations souhaitée.

Après structuration de la partie supérieure en mésa, le masque 31 en résine est ensuite retiré. La structure 111 en mésa de largeur w$_m$ et de hauteur h$_m$, présentant des corrugations latérales 56 de hauteur h' = h$_m$, est ainsi formée (figure 7C).

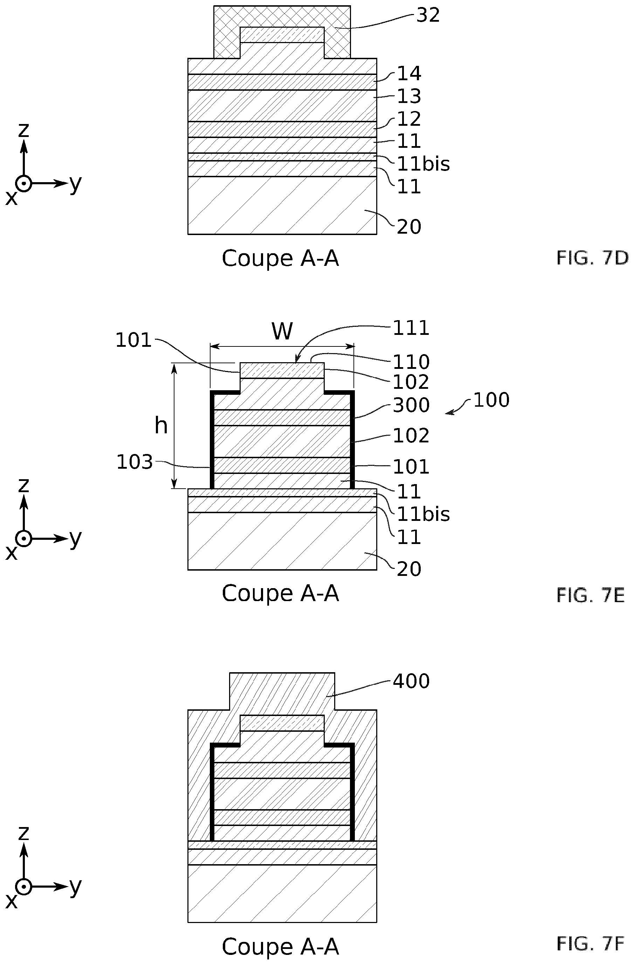

Les figures 7D, 7E illustrent la formation d'un motif de laser dans l'empilement 10 par lithographie/gravure. La figure 7D illustre la formation d'un masque 32 de lithographie à base de résine photosensible sur la structure 111 en mésa, permettant de définir le motif de laser de largeur w. Le motif de laser surmonté par la structure en mésa forme ici le guide d'onde 100 en arête. La figure 7E illustre la gravure des couches 15, 14, 13, 12 et 11 sur une profondeur h - $h_m$, avec arrêt dans la couche 11 bis d'InGaAs dopée. Une telle gravure est connue et peut se faire par gravure sèche anisotrope selon z, par exemple par plasma à couplage inductif ICP (Inductively Coupled Plasma). La couche 11 bis en InGaAs peut être utilisée pour la détection de fin de gravure encore appelée détection de fin d'attaque (DFA).

Après retrait du masque 32, une fine couche 300 de passivation, typiquement en SiN d'épaisseur 300 nm environ, est déposée sur le guide d'onde 100. Cette couche 300 de passivation est ouverte par lithographie/gravure au niveau de la couche 11 bis d'InGaAs dopée, de manière à permettre la formation de l'électrode inférieure, et au niveau de la structure en mésa, de manière à permettre la formation de l'électrode supérieure. La couche de passivation 300 recouvre typiquement les flancs 103, 104 du guide d'onde 100 (figure 7E). De façon préférée, elle ne recouvre pas les flancs latéraux 101, 102 où se trouvent les corrugations latérales, ni la face supérieure 110 au sommet de la structure 111 en mésa.

La figure 7F illustre le dépôt d'une couche métallique 400 destinée à former les électrodes inférieure et supérieure. Cette couche métallique 400 peut comprendre différentes sous-couches, par exemple des couches d'accroche en Ti/TiN et une couche épaisse d'or ou d'alliage AlCu et/ou de tungstène. Cette couche métallique 400 présente de préférence une épaisseur de l'ordre de 1 $\mu$m.

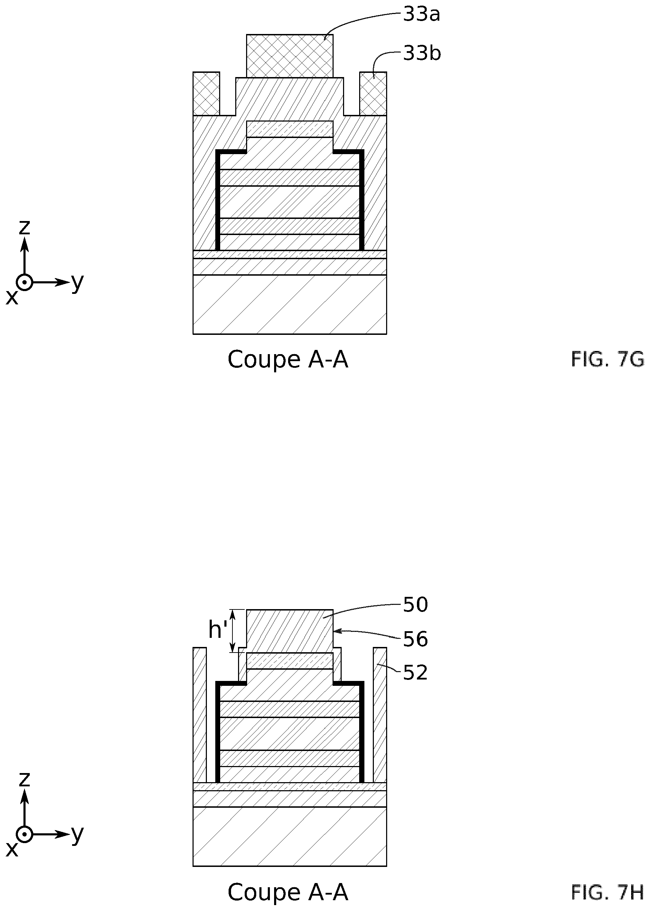

La figure 7G illustre la formation d'un masque 33 de lithographie destiné à définir les électrodes inférieure et supérieure. La largeur de la partie du masque 33 recouvrant la structure en mésa peut être inférieure ou égale à $w_m$, de façon à former une électrode supérieure telle qu'illustrée à la figure 5A. Alternativement, la largeur de la partie du masque 33 recouvrant la structure en mésa peut être strictement supérieure à $w_m$, de façon à former une électrode supérieure telle qu'illustrée aux figures 5B, 5C. Le masque 33 peut présenter un motif de corrugations latérales, sensiblement à l'aplomb des corrugations latérales 56 de la partie supérieure du guide d'onde, de façon à former une électrode supérieure telle qu'illustrée à la figure 5C.

La figure 7H illustre la gravure des zones exposées de la couche métallique 400, de façon à former les électrodes supérieure 50 et inférieure 52. Cette gravure est anisotrope selon z. Elle est configurée pour s'arrêter sur les couches exposées de l'empilement 10. Ainsi, la gravure s'arrête typiquement sur la couche 15. Le masque 33 est ensuite retiré. A l'issue de cette gravure, les corrugations latérales de la structure en mésa peuvent être exposées, ou, de préférence, couvertes par l'électrode supérieure 50.

Le procédé permet avantageusement de réaliser le laser LCQ DFB décrit et illustré précédemment.

L'invention n'est pas limitée aux modes de réalisations précédemment décrits et s'étend à tous les modes de réalisation couverts par les revendications.

Les lasers LCQ DFB réalisés par ce procédé peuvent notamment présenter d'autres architectures, par exemple selon une configuration dite à double tranchée, ou selon une configuration permettant de contacter deux lasers avec une électrode commune.

## Revendications

1. Laser comprenant un miroir de Bragg distribué,

ledit laser étant destiné à émettre un rayonnement lumineux selon une direction longitudinale (x) et comprenant un guide d'onde (100) formé au moins en partie dans un empilement (10) de couches (11, 11bis, 12, 13, 14, 15, 16) à base de matériaux III-V, ledit guide d'onde (100) comprenant au moins une région active (13) configurée pour émettre ledit rayonnement lumineux, ledit empilement (10) présentant une face supérieure (110), l'au moins une région active (13) étant située à une profondeur $h_a$ mesurée selon une première direction transverse (z) perpendiculaire à la direction longitudinale (x) et depuis la face supérieure (110),
ledit miroir de Bragg comprenant des corrugations (56) latérales distribuées périodiquement selon la direction longitudinale (x) selon une période $\Lambda$, lesdites corrugations latérales étant portées par au moins un flanc (101, 102) latéral du guide d'onde (100) parallèle à un plan latéral (xz) défini par la direction longitudinale (x) et la première direction transverse (z), lesdites corrugations (56) latérales présentant une hauteur h' selon la première direction transverse (z) et une dimension d selon une deuxième direction transverse (y) perpendiculaire à la direction longitudinale (x),
lesdites corrugations (56) latérales du miroir de Bragg s'étendant depuis la face supérieure (110) de l'empilement (10), et la hauteur h' des corrugations (56) latérales étant strictement inférieure à la profondeur $h_a$, de sorte qu'une partie (103, 104) de l'au moins un flanc (101, 102) latéral du guide d'onde (100) est dépourvue de corrugations (56) latérales, ladite partie (103, 104) étant située au niveau de l'au moins une région active (13), ledit laser comprenant en outre une électrode supérieure (50) disposée sur la face supérieure (110) du guide d'onde (100), ladite électrode supérieure (50) comprenant une partie supérieure (50a) couvrant la face supérieure (110) du guide d'onde,

ledit laser étant **caractérisé en ce que** ladite électrode supérieure (50) comprend également au moins une partie latérale (50b) couvrant les corrugations (56) latérales.

2. Laser selon la revendication précédente dans lequel les corrugations latérales (56) du miroir de Bragg sont distribuées et dimensionnées de sorte que d/Λ > 1.

3. Laser selon l'une quelconque des revendications précédentes dans lequel l'empilement (10) de couches comprend au moins une couche de confinement optique (14), de préférence à base d'InGaAs, située au-dessus de l'au moins une région active (13), à une profondeur hc selon la première direction transverse (z) depuis la face supérieure (110), et dans lequel les corrugations latérales (56) du miroir de Bragg s'étendent depuis la face supérieure (110) sur une hauteur h' strictement inférieure à hc telle que la partie (103, 104) de l'au moins un flanc (101, 102) latéral du guide d'onde soit dépourvue de corrugations (56) latérales au niveau de ladite couche de confinement optique (14).

4. Laser selon l'une quelconque des revendications précédentes dans lequel les corrugations (56) latérales sont distantes de l'au moins une région active (13) d'une distance $h_a$ - h' selon la première direction transverse (z), $h_a$ - h' étant supérieure ou égale à 200 nm.

5. Laser selon l'une quelconque des revendications précédentes dans lequel la hauteur h' des corrugations latérales (56) du miroir de Bragg est supérieure ou égale à 500 nm.

6. Laser selon l'une quelconque des revendications précédentes dans lequel l'au moins une partie latérale (50b) de l'électrode supérieure (50) présente des corrugations (57) métalliques couvrant les corrugations latérales (56) du miroir de Bragg.

7. Procédé de formation d'un laser comprenant un miroir de Bragg distribué, comprenant :

   - Une fourniture d'un empilement (10) de couches (11, 11 bis, 12, 13, 14, 15, 16) à base de matériaux III-V comprenant au moins une région active (13) destinée à émettre un rayonnement lumineux,
   - Une formation d'un motif de guide d'onde (100) dans l'empilement (10) de couches, ledit motif de guide d'onde (100) présentant une longueur L selon une direction longitudinale (x), une hauteur h selon une première direction transverse (z) et une largeur w selon une deuxième direction transverse (y), les première et deuxième directions transverses (z, y) étant normales à la direction longitudinale (x), ledit motif de guide d'onde (100) présentant une face supérieure (110) et des flancs latéraux (101, 102, 103, 104) s'étendant parallèlement à un plan latéral (xz) défini par la direction longitudinale (x) et la première direction transverse (z),
   - Une structuration dudit motif de guide d'onde (100) de sorte à former des corrugations latérales (56) au niveau desdits flancs latéraux (101, 102), lesdites corrugations latérales (56) étant périodiques de période Λ selon la direction longitudinale (x) et présentant une dimension d selon la deuxième direction transverse (y), et formant au moins en partie le miroir de Bragg distribué, ladite structuration étant configurée de façon à ce que les corrugations (56) latérales du miroir de Bragg s'étendent depuis la face supérieure (110) du motif de guide d'onde selon la première direction transverse (z) sur une hauteur h' strictement inférieure à une profondeur $h_a$ à laquelle est située l'au moins une région active (13) en partant de la face supérieure (110) du motif de guide d'onde, tel qu'une partie (103, 104) des flancs (101, 102) latéraux du guide d'onde est dépourvue de corrugations (56) latérales au niveau de l'au moins une région active (13),
   - Une formation d'un motif d'électrode supérieure (50) au moins en partie sur la face supérieure (110) du motif de guide d'onde (100), ladite formation du motif d'électrode supérieure (50) comprenant un dépôt d'une couche métallique (400) sur la face supérieure (110) et sur les corrugations (56) latérales, et une structuration de ladite couche métallique (400) de sorte que ledit motif d'électrode supérieure (50) présente une partie supérieure (50a) couvrant la face supérieure (110) du guide d'onde et au moins une partie latérale (50b) couvrant les corrugations (56) latérales.

8. Procédé selon la revendication précédente dans lequel l'empilement (10) comprend une couche d'arrêt située au-dessus de l'au moins une région active (13), et la structuration des corrugations (56) latérales est configurée de façon à ce que les corrugations (56) latérales ne s'étendent pas au-delà de ladite couche d'arrêt selon la première direction transverse (z), ladite couche d'arrêt étant située à une profondeur sensiblement égale à h' par rapport à la face supérieure (110) du motif de guide d'onde.

9. Procédé selon la revendication précédente dans lequel la couche d'arrêt est à base d'InGaAs et présente une épaisseur e' comprise entre 20 nm et 200 nm.

10. Procédé selon l'une quelconque des revendications 7 à 9 dans lequel la structuration de la couche métallique (400) est configurée de sorte à ce que l'au moins une partie latérale (50b) du motif d'électrode (50) présente des flancs latéraux (58) parallèles au plan latéral (xz) et exempts de corrugations latérales.

11. Procédé selon l'une quelconque des revendications 7 à 9 dans lequel la structuration de la couche métallique (400) est configurée de sorte à ce que l'au moins une partie latérale (50b) du motif d'électrode (50) présente des corrugations (57) métalliques couvrant les corrugations (56) latérales.

**Patentansprüche**

1. Laser, einen verteilten Bragg-Spiegel umfassend,

   wobei der Laser bestimmt ist, um eine Lichtstrahlung in einer Längsrichtung (x) zu emittieren, und einen Wellenleiter (100) umfassend, der mindestens teilweise in einem Stapel (10) von Schichten (11, 11 bis, 12, 13, 14, 15, 16) gebildet ist, basierend auf III-V-Materialien, wobei der Wellenleiter (100) mindestens einen aktiven Bereich (13) umfasst, der konfiguriert ist, um die Lichtstrahlung zu emittieren, wobei der Stapel (10) eine obere Fläche (110) aufweist, wobei sich der mindestens eine aktive Bereich (13) in einer Tiefe $h_a$ befindet, gemessen in einer ersten Querrichtung (z) perpendikular zur Längsrichtung (x) und von der obere Fläche (110) ausgehend, wobei der Bragg-Spiegel seitliche Wellungen (56) umfasst, die in der Längsrichtung (x) periodisch gemäß einer Periode $\Lambda$ verteilt sind, wobei die seitlichen Wellungen von mindestens einer seitlichen Flanke (101, 102) des Wellenleiters (100) getragen werden, parallel zu einer seitlichen Ebene (xz), die durch die Längsrichtung (x) und die erste Querrichtung (z) definiert ist, wobei die seitlichen Wellungen (56) eine Höhe h' in der ersten Querrichtung (z) aufweisen und eine Dimension d in einer zweiten Querrichtung (y), perpendikular zur Längsrichtung (x),
   wobei sich die seitlichen Wellungen (56) des Bragg-Spiegels von der oberen Fläche (110) des Stapels (10) aus erstrecken, und die Höhe h' der seitlichen Wellungen (56) streng kleiner ist als die Tiefe $h_a$, so dass ein Abschnitt (103, 104) der mindestens einen seitlichen Flanke (101, 102) des Wellenleiters (100) frei von seitlichen Wellungen (56) ist, wobei sich der Abschnitt (103, 104) auf dem Niveau des mindestens einen aktiven Bereichs (13) befindet,
   wobei der Laser ferner eine obere Elektrode (50) umfasst, die auf der oberen Fläche (110) des Wellenleiters (100) angeordnet ist, wobei die obere Elektrode (50) einen oberen Abschnitt (50a) umfasst, der die obere Fläche (110) des Wellenleiters abdeckt,
   wobei der Laser **dadurch gekennzeichnet ist, dass** die obere Elektrode (50) auch mindestens einen seitlichen Abschnitt (50b) umfasst, der die seitlichen Wellungen (56) abdeckt.

2. Laser nach dem vorhergehenden Anspruch, wobei die seitlichen Wellungen (56) des Bragg-Spiegels so verteilt und dimensioniert sind, dass $d/\Lambda > 1$ ist.

3. Laser nach einem der vorhergehenden Ansprüche, wobei der Stapel (10) der Schichten mindestens eine Schicht der optischen Eingrenzung (14) umfasst, vorzugsweise auf InGaAs basierend, die sich über dem mindestens einen aktiven Bereich (13) befindet, in einer Tiefe hc in der ersten Querrichtung (z) von der obere Fläche (110) ausgehend, und wobei sich die seitlichen Wellungen (56) des Bragg-Spiegels von der oberen Fläche (110) aus auf einer Höhe h' erstrecken, die streng kleiner ist als hc, so dass der Abschnitt (103, 104) der mindestens einen seitlichen Flanke (101, 102) des Wellenleiters frei ist von seitlichen Wellungen (56), auf dem Niveau der Schicht der optischen Eingrenzung (14).

4. Laser nach einem der vorhergehenden Ansprüche, wobei die seitlichen Wellungen (56) beabstandet sind von dem mindestens einen aktiven Bereich (13) um einen Abstand $h_a$ - h' in der ersten Querrichtung (z), wobei $h_a$ - h' größer oder gleich 200 nm ist.

5. Laser nach einem der vorhergehenden Ansprüche, wobei die Höhe h' der seitlichen Wellungen (56) des Bragg-Spiegels größer oder gleich 500 nm ist.

6. Laser nach einem der vorhergehenden Ansprüche, wobei der mindestens eine seitliche Abschnitt (50b) der oberen Elektrode (50) metallische Wellungen (57) aufweist, die die seitlichen Wellungen (56) des Bragg-Spiegels abdecken.

**7.** Verfahren zum Bilden eines Lasers, das einen verteilten Bragg-Spiegel umfasst, umfassend:

- eine Bereitstellung eines Stapels (10) von Schichten (11, 11bis, 12, 13, 14, 15, 16) auf III-V-Materialien basierend, die mindestens einen aktiven Bereich (13) umfassen, der dazu bestimmt ist, Lichtstrahlung zu emittieren,
- eine Bildung eines Wellenleitermusters (100) im Stapel (10) der Schichten, wobei das Wellenleitermuster (100) eine Länge L in einer Längsrichtung (x) aufweist, eine Höhe h in einer ersten Querrichtung (z) und eine Breite w in einer zweiten Querrichtung (y), wobei die erste und die zweite Querrichtung (z, y) senkrecht zur Längsrichtung (x) sind, wobei das Wellenleitermuster (100) eine obere Fläche (110) und seitliche Flanken (101, 102, 103, 104) aufweist, die sich parallel zu einer seitlichen Ebene (xz) erstrecken, die durch die Längsrichtung (x) und die erste Querrichtung (z) definiert ist,
- eine Strukturierung des Wellenleitermusters (100), um seitliche Wellungen (56) auf dem Niveau der seitlichen Flanken (101, 102) zu bilden, wobei die seitlichen Wellungen (56) periodisch mit der Periode Λ in der Längsrichtung (x) sind, und eine Dimension d in der zweiten Querrichtung (y) aufweisen, und mindestens teilweise den verteilten Bragg-Spiegel bilden, wobei die Strukturierung so konfiguriert ist, dass sich die seitlichen Wellungen (56) des Bragg-Spiegels von der oberen Fläche (110) des Wellenleitermusters aus in der ersten Querrichtung (z) auf einer Höhe h' erstrecken, die streng kleiner ist als eine Tiefe $h_a$, in der sich der mindestens eine aktive Bereich (13) befindet, von der oberen Fläche (110) des Wellenleitermusters ausgehend, so dass ein Abschnitt (103, 104) der seitlichen Flanken (101, 102) des Wellenleiters frei von seitlichen Wellungen (56) ist, auf dem Niveau des mindestens einen aktiven Bereichs (13),
- eine Bildung eines oberen Elektrodenmusters (50) mindestens teilweise auf der oberen Fläche (110) des Wellenleitermusters (100), wobei die Bildung des oberen Elektrodenmusters (50) eine Abscheidung einer Metallschicht (400) auf der oberen Fläche (110) und auf den seitlichen Wellungen (56) umfasst, und eine Strukturierung der Metallschicht (400), so dass das obere Elektrodenmuster (50) einen oberen Abschnitt (50a) aufweist, der die obere Fläche (110) des Wellenleiters abdeckt, und mindestens einen seitlichen Abschnitt (50b), der die seitlichen Wellungen (56) abdeckt.

**8.** Verfahren nach dem vorhergehenden Anspruch, wobei der Stapel (10) eine Sperrschicht umfasst, die sich über dem mindestens einen aktiven Bereich (13) befindet, und die Strukturierung der seitlichen Wellungen (56) so konfiguriert ist, dass sich die seitlichen Wellungen (56) nicht über die Sperrschicht hinaus erstrecken, in der ersten Querrichtung (z), wobei sich die Sperrschicht in einer Tiefe befindet, die im Wesentlichen gleich h' ist bezüglich der obere Fläche (110) des Wellenleitermusters.

**9.** Verfahren nach dem vorhergehenden Anspruch, wobei die Sperrschicht auf InGaAs basiert und eine Dicke zwischen 20 nm und 200 nm aufweist.

**10.** Verfahren nach einem der Ansprüche 7 bis 9, wobei die Strukturierung der Metallschicht (400) so konfiguriert ist, dass der mindestens eine seitliche Abschnitt (50b) des Elektrodenmusters (50) seitliche Flanken (58) aufweist, die parallel zur seitlichen Ebene (xz) und ohne seitliche Wellungen sind.

**11.** Verfahren nach einem der Ansprüche 7 bis 9, wobei die Strukturierung der Metallschicht (400) so konfiguriert ist, dass mindestens ein seitlicher Abschnitt (50b) des Elektrodenmusters (50) metallische Wellungen (57) aufweist, die die seitlichen Wellungen (56) abdecken.

**Claims**

**1.** A laser comprising a distributed Bragg mirror,

said laser being designed to emit light radiation along a longitudinal direction (x) and comprising a waveguide (100) formed at least in part in a stack (10) of layers (11, 11 bis, 12, 13, 14, 15, 16) made of III-V materials, said waveguide (100) comprising at least one active region (13) configured to emit said light radiation, said stack (10) having a top surface (110), the at least one active region (13) being located at a depth $h_a$ measured along a first transverse direction (z) perpendicular to the longitudinal direction (x) and from the top surface (110), said Bragg mirror comprising lateral corrugations (56) distributed periodically along a longitudinal direction (x) in a period Λ, said lateral corrugations being carried by at least one lateral flank (101, 102) of the waveguide (100) parallel to a lateral plane (xz) defined by the longitudinal direction (x) and the first transverse direction (z), said lateral corrugations (56) having a height h' along a first transverse direction (z) and a dimension d along a second transverse direction (y) perpendicular to the longitudinal direction (x),

said lateral corrugations (56) of the Bragg mirror extending from the top surface (110) of the stack (10), and the height h' of the lateral corrugations (56) being strictly less than the depth $h_a$, such that a portion (103, 104) of the at least one lateral flank (101, 102) of the waveguide (100) is free of any lateral corrugations (56), said portion (103, 104) being located at the level of the at least one active region (13),

said laser also comprising a top electrode (50) arranged on the top surface (110) of the waveguide (100), said top electrode (50) comprising a top portion (50a) covering the top surface (110) of the waveguide,

said laser **characterised in that** said top electrode (50) equally comprises at least one lateral portion (50b) covering the lateral corrugations (56).

2. The laser according to the previous claim wherein the lateral corrugations (56) of the Bragg mirror are distributed and designed such that $d/\Lambda > 1$.

3. The laser according to any one of the previous claims wherein the stack (10) of layers comprises at least one optical confinement layer (14), preferably InGaAs-based, located above the at least one active region (13), at a depth hc along the first transverse direction (z) from the top surface (110), and wherein the lateral corrugations (56) of the Bragg mirror extend from the top surface (110) on a height h' strictly less than hc, such that the portion (103, 104) of the at least one lateral flank (101, 102) of the waveguide is free of any lateral corrugations (56) at the level of said optical confinement layer (14).

4. The laser according to any one of the previous claims wherein the lateral corrugations (56) are far from the at least one active region (13) by a distance $h_a$ - h' along the first transverse direction (z), $h_a$ - h' being greater than or equal to 200 nm.

5. The laser according to any one of the previous claims wherein the height h' of the lateral corrugations (56) of the Bragg mirror is greater than or equal to 500 nm.

6. The laser according to any one of the previous claims wherein the at least one lateral portion (50b) of the top electrode (50) has metal corrugations (57) covering the lateral corrugations (56) of the Bragg mirror.

7. A method for forming a laser comprising a distributed Bragg mirror, comprising:

- Providing a stack (10) of layers (11, 11bis, 12, 13, 14, 15, 16) made of III-V materials comprising at least one active region (13) for emitting light radiation,
- Forming a waveguide (100) pattern in the stack (10) of layers, said waveguide (100) pattern having a length L along a longitudinal direction (x), a height h along a first transverse direction (z) and a width w along a second transverse direction (y), the first and second transverse directions (z, y) being normal to the longitudinal direction (x), said waveguide (100) pattern having a top surface (110) and lateral flanks (101, 102, 103, 104) extending parallel to a lateral plane (xz) defined by the longitudinal direction (x) and the first transverse direction (z),
- Structuring said waveguide (100) pattern so as to form lateral corrugations (56) at the level of said lateral flanks (101, 102), said lateral corrugations (56) being periodic with period $\Lambda$ along the longitudinal direction (x) and having a dimension d along the second transverse direction (y), and at least partly forming the distributed Bragg mirror, said structuring being configured such that the lateral corrugations (56) of the Bragg mirror extend from the top surface (110) of the waveguide pattern along the first transverse direction (z) on a height h' strictly less than the depth $h_a$, at which the at least one active region (13) is located starting from the top surface (110) of the waveguide pattern, such that a portion (103, 104) of the lateral flanks (101, 102) of the waveguide is free of any lateral corrugations (56) at the level of the at least one active region (13),
- Forming a top electrode (50) pattern at least partly on the top surface (110) of the waveguide (100) pattern, said forming of the top electrode (50) pattern comprising a deposition of a metal layer (400) on the top surface (110) and on the lateral corrugations (56), and structuring said metal layer (400) such that said top electrode (50) pattern has a top portion (50a) covering the top surface (110) of the waveguide and at least a lateral portion (50b) covering the lateral corrugations (56).

8. A method according to the previous claim wherein the stack (10) comprises a barrier layer located above the at least one active region (13), and the structuring of the lateral corrugations (56) is configured such that the lateral corrugations (56) do not extend beyond said barrier layer along the first transverse direction (z), said barrier layer being located at a depth substantially equal to h' with respect to the top surface (110) of the waveguide pattern.

9. The method according to the previous claim wherein the barrier layer is InGaAs-based and has a thickness e' of between 20 nm and 200 nm.

10. The method according to any one of claims 7 to 9 wherein the structuring of the metal layer (400) is configured such that the at least one lateral portion (50b) of the electrode (50) pattern has lateral flanks (58) parallel to the lateral plane (xz) and free of any lateral corrugations.

11. The method according to any one of claims 7 to 9 wherein the structuring of the metal layer (400) is configured such that the at least one lateral portion (50b) of the electrode (50) pattern has metal corrugations (57) covering the lateral corrugations (56).

FIG. 1

FIG. 2A

FIG. 2B

FIG. 3A

FIG. 3B

FIG. 3C

Sans DBF

FIG. 4A

Avec DBF

FIG. 4B

FIG. 5A

FIG. 5B

FIG. 5C

FIG. 6A

FIG. 6B

FIG. 6C

Coupe A-A

FIG. 7A

Coupe A-A

FIG. 7B

Coupe A-A

FIG. 7C

32

14
13
12
11
11bis
11
20

z
y
x

Coupe A-A

FIG. 7D

101
W
111
110
102
300
100
102
101
11
11bis
11
20

h
103

z
y
x

Coupe A-A

FIG. 7E

400

z
y
x

Coupe A-A

FIG. 7F

33a

33b

z

x ⊙ → y

Coupe A-A

FIG. 7G

50

h'

56

52

z

x ⊙ → y

Coupe A-A

FIG. 7H

## RÉFÉRENCES CITÉES DANS LA DESCRIPTION

**Documents brevets cités dans la description**

- US 2015333482 A1

- EP 1833128 A1

**Littérature non-brevet citée dans la description**

- **WANG Q.C et al.** *Asia communications and photonics conférence,* 2019, 1-3

- **DRIDI K. et al.** *Asia communications and photonics conférence,* 2012, 1-3